(19)

Europäisches
Patentamt
European
Patent Office
Office européen
des brevets

(11) **EP 4 227 336 A1**

(12) **EUROPEAN PATENT APPLICATION**
published in accordance with Art. 153(4) EPC

(43) Date of publication:
**16.08.2023 Bulletin 2023/33**

(21) Application number: **21877606.0**

(22) Date of filing: **05.10.2021**

(51) International Patent Classification (IPC):
*C08F 290/06* (2006.01)     *C08F 220/26* (2006.01)
*C08F 220/34* (2006.01)     *C08F 220/38* (2006.01)
*C08F 220/58* (2006.01)     *C08F 220/60* (2006.01)
*C08F 230/02* (2006.01)     *C08L 51/08* (2006.01)
*C08L 55/00* (2006.01)     *C08L 83/04* (2006.01)
*C08L 83/05* (2006.01)     *C08L 83/07* (2006.01)
*C09K 5/14* (2006.01)     *C08K 3/01* (2018.01)

(52) Cooperative Patent Classification (CPC):
**C08F 220/26; C08F 220/34; C08F 220/38;
C08F 220/58; C08F 220/60; C08F 230/02;
C08F 290/06; C08K 3/01; C08L 51/08; C08L 55/00;
C08L 83/04; C09K 5/14**

(86) International application number:
**PCT/JP2021/036778**

(87) International publication number:
**WO 2022/075307 (14.04.2022 Gazette 2022/15)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **05.10.2020   JP 2020168732**

(71) Applicant: **Denka Company Limited
Tokyo 103-8338 (JP)**

(72) Inventors:
• **IGARASHI, Kazuyuki
Tokyo 103-8338 (JP)**
• **ONOZUKA, Masao
Tokyo 103-8338 (JP)**

(74) Representative: **Zacco Sweden AB
P.O. Box 5581
Löjtnantsgatan 21
114 85 Stockholm (SE)**

(54) **HEAT-CONDUCTIVE RESIN COMPOSITION AND ELECTRONIC APPARATUS**

(57)     The thermally conductive resin composition containing: 5 to 95 parts by weight of a copolymer (a) having a (meth)acrylic monomer unit A having an anionic group, a (meth)acrylic monomer unit B having a cationic group, and a silicone (meth)acrylic monomer unit C; 95 to 5 parts by weight of a silicone resin (b); and 500 to 3000 parts by weight of a thermally conductive filler (c) having a thermal conductivity of 10 W/mK or more, wherein a total content of the copolymer (a) and the silicone resin (b) is 100 parts by weight, and the silicone resin (b) includes a crosslinked silicone resin (b-1), wherein a content of the crosslinked silicone resin (b-1) is 5 to 100 mass% based on the total amount of the silicone resin (b) .

Fig.1

EP 4 227 336 A1

**Description**

Technical Field

The present invention relates to a thermally conductive resin composition and an electronic device using the same.

Background Art

The amount of heat per unit area generated from heat-generating electronic components such as CPU (central processing unit) in personal computers is becoming very large with downsizing and higher power of these electronic components. This amount of heat reaches even about 20 times that of clothes irons. The cooling of such a heat-generating electronic component is necessary for preventing the failure of the heat-generating electronic component over a long period.

In the cooling, a metal heat sink or housing is used, and further, a thermally conductive material is used for efficiently transferring heat from a heat-generating electronic component to a cooling part such as a heat sink or a housing. When a heat-generating electronic component is in contact with a heat sink or the like without a thermally conductive material, air microscopically exists at the interface therebetween and hinders thermal conduction. Hence, a thermally conductive material, instead of the air that exists at the interface, is allowed to exist between the heat-generating electronic component and the heat sink or the like, thereby efficiently transferring heat.

The thermally conductive material includes, for example, thermally conductive pads or thermally conductive sheets formed in a sheet shape in which a thermally conductive filler is filled into a thermosetting resin, thermally conductive greases that permit coating or thin film formation in which a thermally conductive filler is filled into a resin having fluidity, and phase-change thermally conductive materials that soften or fluidize at operating temperatures of heat-generating electronic components.

Heat radiation materials in a sheet shape, which are easy to handle and are excellent in long-term shape retentivity, have large contact thermal resistance and are inferior in automatic implementation to a grease state. Accordingly, in recent years, heat radiation greases have been increasingly used with a thickness of 0.3 mm or more where sheets have typically been used. Such greases are often used in vertical placement. Thus, there is a demand for a thermally conductive grease that achieves both coatability and creep resistance.

Such a heat radiation grease includes, generally in a resin, an inorganic filler surface treated by a silane coupling agent and the like. A surface treatment agent other than a silane coupling agent which has been known is, for example, a copolymer including a polybutadiene constitutional unit, a constitutional unit having a hydrolyzable silyl group, and a constitutional unit having a polysiloxane skeleton (for example, see Patent Literature 1).

However, a blend with a low-molecular compound such as a silane coupling agent generates voids by volatilization with the heat generation of an electronic component, thereby reducing heat radiation performance. Also, a blend with an oligomer or the like having a hydrolyzable group in a chain reduces adhesion due to the bleeding of components over time, thereby still reducing heat radiation performance. In order to solve these problems, Patent Literature 1 has proposed use of a high-molecular-weight surface treatment agent.

When a heat radiation grease is used in vertical placement, creeping (dripping, pump-out phenomenon) occurs due to thermal shock or the like so that a heat radiation property is more easily reduced. In order to solve this problem, in Patent Literature 2, creep resistance is improved by crosslinking organopolysiloxane including a thermally conductive filler with an organic peroxide. Also, creep resistance is improved by mixing with a specific ratio of an iron oxide filler in Patent Literature 3 and an aluminum hydroxide filler in Patent Literature 4.

Citation List

Patent Literature

Patent Literature 1
Japanese Patent Laid-Open No. 2018-062552
Patent Literature 2
Japanese Patent Laid-Open No. 2017-226724
Patent Literature 3
Japanese Patent Laid-Open No. 2015-140395
Patent Literature 4

Japanese Patent No. 5300408

Summary of Invention

Technical Problem

However, use of the high-molecular-weight surface treatment agent as disclosed in Patent Literature 1 poses a problem of increasing a grease viscosity and reducing coating performance (fluidity). When a heat radiation grease which uses the conventional surface treatment agent and a dispersant is retained for an extended period of time at a high temperature, it has been revealed that distribution rupture is caused and cracks occur due to the re-agglomeration of a filler so that heat can no longer escape efficiently, reducing heat radiation characteristics. Such reduction in heat radiation performance also induces the reduction in reliability of electronic devices.

In Patent Literature 2, the half-life of the organic peroxide is set to 10 hours at a predetermined temperature, still leaving a problem with creep resistance for an extended period of time. In Patent Literatures 3 and 4, since there is a limitation on the thermally conductive filler that may be used, the resulting heat radiation grease loses the degree of freedom of design and has the difficulty in exerting sufficient heat radiation characteristics.

The present invention was made in light of the above problems and aims to provide a thermally conductive resin composition that has good fluidity without being limited by the type of a thermally conductive filler, can maintain the dispersibility of a thermally conductive filler even when retained for an extended period of time in a state of high temperature, can prevent voids and cracks, suppresses bleed-out, and is also excellent in creep resistance, and an electronic device using the same.

Solution to Problem

The present invention was made in light of the above problems and has been accomplished by finding that use of a copolymer comprising predetermined monomer units, and a crosslinked silicone resin can solve the above problems

More specifically, the present invention is as follows.

[1] A thermally conductive resin composition comprising:

5 to 95 parts by weight of a copolymer (a) having a (meth)acrylic monomer unit A having an anionic group, a (meth)acrylic monomer unit B having a cationic group, and a silicone (meth)acrylic monomer unit C;
95 to 5 parts by weight of a silicone resin (b); and
500 to 3000 parts by weight of a thermally conductive filler (c) having a thermal conductivity of 10 W/mK or more, wherein
a total content of the copolymer (a) and the silicone resin (b) is 100 parts by weight, and
the silicone resin (b) includes a crosslinked silicone resin (b-1), wherein
a content of the crosslinked silicone resin (b-1) is 5 to 100 mass% based on the total amount of the silicone resin (b).

[2] The thermally conductive resin composition according to [1], wherein

the silicone resin (b) further comprises a non-crosslinked silicone resin (b-2), wherein
the content of the crosslinked silicone resin (b-1) is 5 to 99 mass% based on the total amount of the silicone resin (b), and
a content of the non-crosslinked silicone resin (b-2) is 95 to 1 mass% based on the total amount of the silicone resin (b).

[3] The thermally conductive resin composition according to [2], wherein
the non-crosslinked silicone resin (b-2) is linear polyorganosiloxane.
[4] The thermally conductive resin composition according to [2] or [3], wherein
a viscosity of the non-crosslinked silicone resin (b-2) is 1 to 10,000 mPa·s as a value measured at a shear velocity of 10 sec$^{-1}$ at 25°C.
[5] The thermally conductive resin composition according to any one of [1] to [4], wherein
the crosslinked silicone resin (b-1) is prepared through the reaction between polyorganosiloxane (b-1-1) having two or more alkenyl groups in a molecule and polyorganosiloxane (b-1-2) containing two or more SiH groups in a molecule.
[6] The thermally conductive resin composition according to any one of [1] to [5], wherein
the anionic group comprises one or more selected from the group consisting of carboxy groups, phosphate groups, and phenolic hydroxy groups.

[7] The thermally conductive resin composition according to any one of [1] to [6], wherein
the (meth)acrylic monomer unit A further has an electron-withdrawing group bound to the anionic group.

[8] The thermally conductive resin composition according to any one of [1] to [7], wherein
the cationic group comprises one or more selected from the group consisting of primary amino groups, secondary amino groups, tertiary amino groups, and quaternary ammonium salts.

[9] The thermally conductive resin composition according to any one of [1] to [8], wherein
the (meth)acrylic monomer unit B further has an electron-donating group bound to the cationic group.

[10] The thermally conductive resin composition according to any one of [1] to [9], wherein
a weight average molecular weight of the copolymer (a) is 5,000 to 500,000.

[11] The thermally conductive resin composition according to any one of [1] to [10], wherein
a total content of the (meth)acrylic monomer unit A and the (meth)acrylic monomer unit B is 0.05 to 90 mol% based on the total 100 mol% of the (meth)acrylic monomer unit A, the (meth)acrylic monomer unit B, and the silicone (meth)acrylic monomer unit C.

[12] The thermally conductive resin composition according to any one of [1] to [11], wherein
a content of the (meth)acrylic monomer unit A is 0.03 to 85 mol% based on the total 100 mol% of the (meth)acrylic monomer unit A, the (meth)acrylic monomer unit B, and the silicone (meth)acrylic monomer unit C.

[13] The thermally conductive resin composition according to any one of [1] to [12], wherein
a content of the (meth)acrylic monomer unit B is 0.1 to 10 mol% based on the total 100 mol% of the (meth)acrylic monomer unit A, the (meth)acrylic monomer unit B, and the silicone (meth)acrylic monomer unit C.

[14] The thermally conductive resin composition according to any one of [1] to [13], wherein
a content of the silicone (meth)acrylic monomer unit C is 10 to 99.5 mol% based on the total 100 mol% of the (meth)acrylic monomer unit A, the (meth)acrylic monomer unit B, and the silicone (meth)acrylic monomer unit C.

[15] The thermally conductive resin composition according to any one of [1] to [14], wherein
a molar ratio of the (meth)acrylic monomer unit A to the (meth)acrylic monomer unit B is 0.01 to 50.

[16] The thermally conductive resin composition according to any one of [1] to [15], comprising
0.01 to 5 parts by weight of a surface treatment agent (d) based on 100 parts by weight of the thermally conductive filler (c).

[17] The thermally conductive resin composition according to any one of [1] to [16], wherein
the thermally conductive filler (c) is one or more selected from among aluminum, aluminum hydroxide, aluminum oxide, aluminum nitride, boron nitride, zinc oxide, magnesium oxide, and diamond.

[18] An electronic device comprising

a heat generator, a heat sink, and the thermally conductive resin composition according to any one of [1] to [17] or a hardened product thereof, wherein
the thermally conductive resin composition or the hardened product is disposed between the heat generator and the heat sink.

Advantageous Effects of Invention

The present invention can accordingly provide a thermally conductive resin composition that has good fluidity without being limited by the type of a thermally conductive filler, can maintain the dispersibility of a thermally conductive filler even when retained for an extended period of time in a state of high temperature, can prevent voids and cracks, suppresses bleed-out, and is also excellent in creep resistance, and an electronic device using the same.

Brief Description of Drawings

[Figure 1] Figure 1 is a schematic view illustrating a method for testing a dripping property in Examples.
[Figure 2] Figure 2 is a schematic view illustrating a method for testing a dripping property in Examples.

Description of Embodiments

Hereinafter, embodiments of the present invention (hereinafter, referred to as "the present embodiment") will be described in detail but the present invention is not limited thereto and numerous alterations can be employed without departing from the scope of the disclosed subject matter.

[Thermally conductive resin composition]

The thermally conductive resin composition of the present embodiment comprises: 5 to 95 parts by weight of a copolymer (a) having a (meth)acrylic monomer unit A having an anionic group, a (meth)acrylic monomer unit B having a cationic group, and a silicone (meth)acrylic monomer unit C; 95 to 5 parts by weight of a silicone resin (b); and 500 to 3000 parts by weight of a thermally conductive filler (c) having a thermal conductivity of 10 W/mK or more, wherein a total content of the copolymer (a) and the silicone resin (b) is 100 parts by weight, and the silicone resin (b) includes a crosslinked silicone resin (b-1), wherein a content of the crosslinked silicone resin (b-1) is 5 to 100 mass% based on the total amount of the silicone resin (b).

With the above copolymer (a) being used, the thermally conductive resin composition of the present embodiment can maintain the dispersibility of the thermally conductive filler (c) even when the thermally conductive filler (c) is highly filled into the silicone resin (b). Particularly, with the copolymer (a) being used, diverse thermally conductive fillers can be used, and the thermally conductive resin composition is capable of preventing voids and cracks even when retained for an extended period of time at a high temperature.

With the crosslinked silicone resin (b-1) being used, the thermally conductive resin composition of the present embodiment can suppress the bleed-out of the silicone resin (b) and is capable of improving creep resistance.

[Copolymer (a)]

The copolymer (a) has a (meth)acrylic monomer unit A having an anionic group, a (meth)acrylic monomer unit B having a cationic group, and a silicone (meth)acrylic monomer unit C. The copolymer (a) of the present embodiment can maintain the dispersibility of the thermally conductive filler (c) even when retained for an extended period of time in a state of high temperature because of the above constitution. The reason therefor is considered as below but not limited thereto.

A predetermined potential difference is caused at an interface where two different substances are in contact as in the surface of a dispersoid dispersed in a disperse medium, and counter ions are attracted, whereby an electrical double layer consisting of a stationary phase and a diffuse double layer is formed. The spread of counter ions at the surface of a dispersoid is also called the thickness of an electrical double layer. When dispersoid particles come closer to each other, counter ions overlap thereby increasing the force of repulsion. The copolymer (a) of the present embodiment having both anionic groups and cationic groups in a molecule is considered to have an action for increasing the thickness of this electrical double layer. More specifically, one of the anionic group and the cationic group of the copolymer (a) is placed close to the surface of the dispersoid as the counter ion. The other group which does not function as the counter ion (subion) is placed farther than the surface of the dispersoid at which a subion layer can further be formed. The thus increased thickness of an electrical double layer at the surface of the thermally conductive filler (c) can apply electrostatic repulsion at a farther distance from the surface of the dispersoid where the Van der Waals force acts, whereby the copolymer (a) is considered to be capable of well maintaining the dispersibility of the dispersoid even when retained for an extended period of time in a state of high temperature.

In the present embodiment, the "monomer" refers to a monomer having a polymerizable unsaturated bond before polymerization, the "monomer unit" refers to a repeating unit constituting a part of the copolymer (a) after polymerization and derived from a predetermined monomer. (Meth)acryl includes acryl and methacryl, and the (meth)acrylic monomer includes (meth)acrylate and (meth)acrylamide. Hereinafter, the "(meth)acrylic monomer unit A", etc. is also simply called the "unit A", etc.

((Meth)acrylic monomer unit A having an anionic group)

The (meth)acrylic monomer unit A is a repeating unit having an anionic group. The anionic group is not particularly limited, and examples include carboxy groups, phosphate groups, phenolic hydroxyl groups, and sulfonate groups. Of these, one or more selected from the group consisting of carboxy groups, phosphate groups, and phenolic hydroxyl groups are preferable. With such a group, the dispersibility of the dispersoid tends to be more improved.

The unit A further preferably has an electron-withdrawing group bound to the anionic group. Such an electron-withdrawing group is not particularly limited as long as it has an action for stabilizing the anion of the anionic group. For example, usable is an acrylic monomer including an electron-withdrawing substituent such as halogen in the $\alpha$-position of the carbon atom of a carboxy group. With such a group, the dispersibility of the dispersoid tends to be more improved.

The unit A preferably has no electron-donating group bound to the anionic group or has a low electron-donating group. Such an electron-donating group is not particularly limited as long as it has an action for destabilizing the anion of the anionic group. For example, usable is an acrylic monomer including no electron-donating substituent such as a methyl group in the $\alpha$-position of the carbon atom of a carboxy group. With such a structure, the dispersibility of the dispersoid tends to be more improved.

Such a (meth)acrylic monomer is not particularly limited, and examples include acrylic acid, methacrylic acid, acid phosphoxypropyl methacrylate, acid phosphoxypolyoxyethylene glycol monomethacrylate, acid phosphoxypolyoxypropylene glycol monomethacrylate, phosphoric acid-modified epoxy acrylate, 2-acryloyloxyethyl phosphate, 2-methacryloyloxyethyl acid phosphate, 4-hydroxyphenyl acrylate, 4-hydroxyphenyl methacrylate, 2-methacryloyloxyethyl succinic acid, and 2-acrylamido-2-methylpropanesulfonic acid. Of these, acrylic acid, 2-methacryloyloxyethyl phosphate, 4-hydroxyphenyl methacrylate, and 2-acrylamido-2-methylpropanesulfonic acid are preferable, with acrylic acid being more preferable. With the inclusion of the unit derived from these monomers, the affinity to the dispersoid is more improved, and the dispersibility of the dispersoid tends to be more improved. The unit A can be used singly, or two or more can be used in combination.

((Meth)acrylic monomer unit B having a cationic group)

The (meth)acrylic monomer unit B is a repeating unit having a cationic group. The cationic group is not particularly limited and is preferably, for example, one or more selected from the group consisting of primary amino groups, secondary amino groups, tertiary amino groups, and quaternary ammonium salts. Of these, tertiary amino groups are more preferable. With such a group, the dispersibility of the dispersoid tends to be improved.

The unit B further preferably has an electron-donating group bound to the cationic group. Such an electron-donating group is not particularly limited as long as it has an action for stabilizing the cation of the cationic group. For example, usable is an acrylic monomer including an electron-donating substituent such as a methyl group in the $\alpha$-position of the carbon atom of an amino group. With such a group, the dispersibility of the dispersoid tends to be more improved.

The unit B preferably has no electron-withdrawing group bound to the cationic group or has a low electron-withdrawing group. Such an electron-withdrawing group is not particularly limited as long as it has an action for destabilizing the cation of the cationic group. For example, usable is an acrylic monomer including no electron-withdrawing substitute such as a carboxy group in the $\alpha$-position of the carbon atom of an amino group. With such a structure, the dispersibility of the dispersoid tends to be more improved.

Such a (meth)acrylic monomer is not particularly limited, and examples include 1-aminoethyl acrylate, 1-aminopropyl acrylate, 1-aminoethyl methacrylate, 1-aminopropyl methacrylate, dimethylaminoethyl methacrylate, diethylaminoethyl methacrylate, t-butylaminoethyl (meth)acrylate, dimethylaminoethyl methacrylate quaternary salts, 1,2,2,6,6-pentamethyl-4-piperidyl methacrylate, 2,2,6,6-tetramethyl-4-piperidyl methacrylate, and dimethylamino ethylacrylate benzyl chloride quaternary salts. Of these, 1,2,2,6,6-pentamethyl-4-piperidyl methacrylate and 2,2,6,6-tetramethyl-4-piperidyl methacrylate are preferable, with 1,2,2,6,6-pentamethyl-4-piperidyl methacrylate being more preferable. With the inclusion of the unit derived from these monomers, the affinity to the dispersoid is more improved, and the dispersibility of the dispersoid tends to be more improved. The unit B can be used singly, or two or more can be used in combination.

((Meth)acrylic monomer unit C)

The (meth)acrylic monomer unit C is a silicone(meth)acrylic monomer unit and is a (meth)acrylic monomer including no cationic group or anionic group in a molecule and having a silicone group.

Given that the copolymer (a) is mixed with a resin composition including a thermoplastic resin or a thermosetting resin, the (meth)acrylic monomer C preferably has a skeleton with high affinity or compatibility with the resin used in the resin composition. The (meth)acrylic monomer C has, as such a skeleton, a silicone skeleton such as dimethyl siloxane, methylphenyl siloxane, or diphenyl siloxane. With such a skeleton, the compatibility with a resin to be disperse medium is more improved, and the dispersibility of the dispersoid in the resin composition tends to be more improved.

Such a (meth)acrylic monomer is not particularly limited, and examples include (meth)acrylic monomers having the siloxane skeleton such as $\alpha$-butyl-$\omega$-(3-methacryloxypropyl)polydimethylsiloxane. The unit C can be used singly, or two or more can be used in combination.

The number average molecular weight of the (meth)acrylic monomer C is preferably 300 to 20000, more preferably 1000 to 15000, and further preferably 3000 to 12500. When a number average molecular weight of the (meth)acrylic monomer C is 300 or more, the affinity to the disperse medium is more improved, and the dispersibility of the dispersoid tends to be more improved. When a number average molecular weight of the (meth)acrylic monomer C is 20000 or less, the viscosity of the composition obtained when the copolymer (a) is mixed with other resins and other ingredients more reduces, and the handleability tends to be more improved.

The total content of the unit A and the unit B is, based on the total 100 mol% of the unit A, the unit B, and the unit C, preferably 0.05 to 90 mol%, more preferably 0.2 to 80 mol%, and further preferably 0.5 to 75 mol%. When the total content of the unit A and the unit B is 0.05 mol% or more, the affinity to the disperse medium is more improved, and the dispersibility of the dispersoid tends to be more improved. When the total content of the unit A and the unit B is 90 mol% or less, the viscosity of the composition obtained when the copolymer (a) is mixed with other resins and other ingredients more reduces, and the handleability tends to be more improved.

The content of the unit A is, based on the total 100 mol% of the unit A, the unit B, and the unit C, preferably 0.03 to 85 mol%, more preferably 0.05 to 80 mol%, and further preferably 0.10 to 75 mol%. When a content of the unit A is 0.03 mol% or more, the affinity to the disperse medium is more improved, and the dispersibility of the dispersoid tends to be more improved. When a content of the unit A is 85 mol% or less, the viscosity of the composition obtained when the copolymer (a) is mixed with other resins and other ingredients more reduces, and the handleability tends to be more improved.

The molar ratio of the unit A to the unit B is preferably 0.01 to 50, more preferably 1.0 to 45, and further preferably 5.0 to 40. When a molar ratio of the unit A to the unit B is within the above range, the affinity to the disperse medium is more improved, and the dispersibility of the dispersoid tends to be more improved.

The content of the unit B is, based on the total 100 mol% of the unit A, the unit B, and the unit C, preferably 0.1 to 10 mol%, more preferably 1.0 to 7.5 mol%, and further preferably 1.0 to 5.0 mol%. When a content of the unit B is 0.1 mol% or more, the affinity to the filler tends to be more improved. When a content of the unit B is 10 mol% or less, the handleability derived from the viscosity of the copolymer (a) tends to be more improved.

The content of the unit C is, based on the total 100 mol% of the unit A, the unit B, and the unit C, preferably 10 to 99.5 mol%, more preferably 20 to 95 mol%, and further preferably 25 to 90 mol%. When a content of the unit C is 10 mol% or more, the handleability derived from the viscosity of the copolymer (a) tends to be more improved. When a content of the unit C is 99.5 mol% or less, the affinity to the filler tends to be more improved.

The weight average molecular weight of the copolymer (a) is preferably 5,000 to 500,000, more preferably 7,000 to 150,000, and further preferably 10,000 to 100,000. When a weight average molecular weight of the copolymer (a) is 5,000 or more, the copolymer (a) can maintain the dispersibility even when retained for an extended period of time in a state of high temperature, and the increase in hardness of the composition can be inhibited. When a weight average molecular weight of the copolymer (a) is 5,000 or more, the shape retentivity of the composition when blended with the thermally conductive filler (c) and resins is improved, and the resistance against slipping and dripping of the composition becomes better when coated on a slanting surface or perpendicular surface. When a weight average molecular weight of the copolymer (a) is 500,000 or less, the viscosity of the composition obtained when the copolymer (a) is mixed with other resins and other ingredients more reduces, and the handleability tends to be more improved. The weight average molecular weight can be determined by GPC (gel permeation chromatography).

The content of the copolymer (a) is, based on the total 100 parts by weight of the copolymer (a) and the silicone resin (b), 5 to 95 parts by weight, preferably 5 to 70 parts by weight, and more preferably 5 to 50 parts by weight. When a content of the copolymer (a) is within the above range, the fluidity and the dispersibility of the thermally conductive filler are more improved and the voids and cracks are more prevented.

[Production method of the copolymer (a)]

The method for producing the copolymer (a) of the present embodiment is not particularly limited, and a known polymerization method for a (meth)acrylic monomer can be used. Examples of the polymerization method include radical polymerizations and anionic polymerizations. Of these, radical polymerizations are preferable.

The thermal polymerization initiator used for the radical polymerization is not particularly limited, and examples include azo compounds such as azobisisobutyronitrile; and organic peroxides such as benzoyl peroxide, tert-butyl hydroperoxide, and di-tert-butyl peroxide. The photopolymerization initiator used for the radical polymerization is not particularly limited, and examples include benzoin derivatives. Known polymerization initiators used for the living radical polymerization such as ATRP and RAFT can also be used.

The polymerization conditions are not particularly limited and can be suitably adjusted in accordance with an initiator, a boiling point of a solvent, and additionally the kind of monomers to be used.

The addition sequence of monomers is not particularly limited and, for example, the monomers are mixed and the polymerization is initiated in the light of synthesizing a random copolymer, or the monomers are added sequentially to the polymerization system in the light of synthesizing a block copolymer.

[Silicone resin (b)]

The silicone resin (b) includes a crosslinked silicone resin (b-1) and may further includes a non-crosslinked silicone resin (b-2) as needed. The term "crosslinked" herein refers to a three-dimensionally crosslinked silicone resin, and the term "non-crosslinked" refers to a linear or cyclic silicone resin having no three-dimensional crosslink. The silicone resin (b) can be used singly, or two or more can be used in combination.

(Crosslinked silicone resin (b-1))

The crosslinked silicone resin (b-1) is not particularly limited as long as it has a three-dimensional crosslink. Examples include non-curable silicone resins and curable silicone resins. Of these, a non-curable silicone resin is preferable as the crosslinked silicone resin (b-1). With such a crosslinked silicone resin (b-1) being used, the bleed-out is suppressed and the creep resistance tends to be more improved.

The crosslinked silicone resin (b-1) is preferably prepared through the reaction between polyorganosiloxane (b-1-1) having two or more alkenyl groups in a molecule and polyorganosiloxane (b-1-2) containing two or more SiH groups in a molecule. Examples of such polyorganosiloxane (b-1-1) and polyorganosiloxane (b-1-2) include addition curable silicone resins described later.

From another viewpoint, the crosslinked silicone resin (b-1) preferably has a trifunctional unit ($RSiO_{3/2}$) or a tetrafunctional unit ($SiO_{4/2}$) as a crosslinking point.

General silicone resins can be represented by a monofunctional unit ($R^1SiO_{1/2}$), a bifunctional unit ($R^2SiO_{2/2}$), a trifunctional unit ($R^3SiO_{3/2}$), and a tetrafunctional unit ($SiO_{4/2}$). For example, a linear silicone resin can be expressed as having a monofunctional unit ($R^1SiO_{1/2}$) constituting an end, and a bifunctional unit ($R^2SiO_{2/2}$) constituting the backbone (in the formula given below, n3,n4 = 0), and a cyclic silicone resin can be expressed as having a bifunctional unit ($RSiO_{2/2}$) constituting a ring (in the formula given below, n1,n3,n4 = 0). A three-dimensionally crosslinked silicone resin can be expressed as having a trifunctional unit ($R^3SiO_{3/2}$) and/or a tetrafunctional unit ($SiO_{4/2}$) constituting a branch point, and further having a monofunctional unit ($R^1SiO_{1/2}$) constituting an end of a branched chain, and a bifunctional unit ($R^2SiO_{2/2}$) constituting the branched chain.

A compositional formula using such units can be expressed as given below. In the formula given below, n1 to n4 each represent a compositional ratio of each unit and can be indicated by a ratio such that the sum of n1 to n4 is 1. Whether or not to include these units can be determined by a known method such as Si-NMR.

$$(R^1SiO_{1/2})_{n1}(R^2SiO_{2/2})_{n2}(R^3SiO_{3/2})_{n3}(SiO_{4/2})_{n4}$$

$R^1$ to $R^4$ can each independently represent an optional group. For example, as for addition curable silicone, they can each represent a hydrogen atom or an alkenyl group. Provided that $R^1$ is a hydrogen atom or an alkenyl group, a functional group that contributes to addition curing exists at a chain end. Provided that $R^2$ is a hydrogen atom or an alkenyl group, a functional group that contributes to addition curing exists. In addition, $R^1$ to $R^4$ may each represent an alkoxy group having 1 to 10 carbon atoms, an alkyl group having 1 to 10 carbon atoms, and an aryl group having 6 to 10 carbon atoms that does not contribute to reaction. These functional groups are examples for illustrating the formula. The functional groups are not particularly limited, and conventionally known ones can be used.

In the above description, when the crosslinked silicone resin (b-1) has a trifunctional unit ($RSiO_{3/2}$) or a tetrafunctional unit ($SiO_{4/2}$) as a crosslinking point, each R independently represents a hydrogen atom, an alkenyl group having 2 to 6 carbon atoms, an alkoxy group having 1 to 10 carbon atoms, a hydroxyl group, an alkyl group having 1 to 10 carbon atoms, and an aryl group having 6 to 10 carbon atoms. The crosslinked silicone resin (b-1) may have a monofunctional unit ($R^1SiO_{1/2}$) constituting an end of a branched chain, and a bifunctional unit ($R^2SiO_{2/2}$) constituting the branched chain, and such a monofunctional unit and/or a bifunctional unit can have a reactive functional group such as a hydrogen atom, an alkenyl group, an alkoxy group, or a hydroxyl group.

The content of the crosslinked silicone resin (b-1) is, based on 100 mass% of the silicone resin (b), 5 to 99 mass%, preferably 5 to 90 mass%, more preferably 10 to 60 mass%, further preferably 10 to 40 mass%. When a content of the crosslinked silicone resin (b-1) is within the above range, the fluidity and the dispersibility of the thermally conductive filler are more improved and the voids and cracks are more prevented. In addition, the bleed-out is suppressed and the creep resistance tends to be more improved.

(Non-crosslinked silicone resin (b-2))

Examples of the non-crosslinked silicone resin (b-2) include linear polyorganosiloxane or cyclic polyorganosiloxane. Of these, linear polyorganosiloxane is preferable, and a silicone oil which is linear polyorganosiloxane is more preferable. With such a non-crosslinked silicone resin being used, the fluidity and the dispersibility of the thermally conductive filler are more improved and the voids and cracks tend to be more prevented.

Examples of the non-crosslinked silicone resin (b-2) include non-curable silicone resins and curable silicone resins. Of these, non-curable silicone resins are preferable. With such a non-crosslinked silicone resin (b-2) being used, the bleed-out is suppressed and the creep resistance tends to be more improved.

The content of the non-crosslinked silicone resin (b-2) is, based on 100 parts by weight of the silicone resin (b), preferably 1 to 95 mass%, more preferably 10 to 95 mass%, and further preferably 40 to 90 mass%. When a content of the non-crosslinked silicone resin (b-2) is within the above range, the fluidity and the dispersibility of the thermally conductive filler are more improved and the voids and cracks tend to be more prevented.

The viscosity of the silicone resin (b) is, as a value measured at a shear velocity of 10 sec$^{-1}$ at 25°C, preferably 1 to 10000 mPa·s, more preferably 10 to 5000 mPa·s, and further preferably 50 to 2000 mPa·s. When a viscosity of the silicone resin (b) is within the above range, the fluidity and the dispersibility of the thermally conductive filler are more improved and the voids and cracks tend to be more prevented. When a plurality types of silicone resins (b) are used in mixture, the above viscosity is the viscosity of the whole silicone resin (b) mixture.

The content of the silicone resin (b) is, based on the total 100 parts by weight of the copolymer (a) and the silicone resin (b), preferably 95 to 5 parts by weight, more preferably 95 to 30 parts by weight, and further preferably 95 to 50 parts by weight. When a content of the silicone resin (b) is within the above range, the fluidity and the dispersibility of the thermally conductive filler are more improved and the voids and cracks are more prevented.

Particularly, the viscosity of the non-crosslinked silicone resin (b-2) is, as a value measured at a shear velocity of 10 sec$^{-1}$ at 25°C, preferably 1 to 10000 mPa·s, more preferably 50 to 5000 mPa·s, and further preferably 100 to 2000 mPa·s. When a viscosity of the non-crosslinked silicone resin (b-2) is within the above range, the fluidity and the dispersibility of the thermally conductive filler are more improved and the voids and cracks are more prevented. In addition, the bleed-out is suppressed and the creep resistance tends to be more improved.

(Non-curable silicone resin and curable silicone resin)

The non-curable silicone resin is not particularly limited as long as it neither has a functional group that is contained in the curable silicone resin described later and contributes to curing, nor is used in combination with a catalyst.

The curable silicone resin is not particularly limited, and a conventionally known one can be used. Examples of the form of its hardening include addition curable silicone resins, condensation curable silicone resins, and peroxide curable silicone resins. The curable silicone resin can also be classified into one-component type including all hardening components, and two-component type which is hardened by mixing two agents.

The silicone resin (b) may be a non-curable silicone resin and a curable silicone resin used in combination. Examples of such a combination include combinations of a non-curable silicone resin and an addition curable silicone resin, combinations of a non-curable silicone resin and a condensation curable silicone resin, and combinations of a non-curable silicone resin, an addition curable silicone resin, and a condensation curable silicone resin. Of these, combinations of a non-curable silicone resin and an addition curable silicone resin are preferable.

Hereinafter, specific forms of the non-curable silicone resin and the curable silicone resin will be illustrated.

Examples of the non-curable silicone resin include polyorganosiloxane having neither an addition reactive functional group nor a condensation reactive functional group. Such polyorganosiloxane is not particularly limited, and examples include polydimethylsiloxane, polymethylphenylsiloxane, polydiphenylsiloxane, and copolymers and modified forms thereof. Examples of the modified forms include forms in which some methyl groups or phenyl groups are modified with alkyl, aralkyl, fluoroalkyl, polyether, amino, acryl, epoxy, or the like.

With such a non-curable polyorganosiloxane being used, the thermally conductive resin composition does not have to undergo hardening reaction and can therefore eliminate influence ascribable to the hardening reaction. Examples of the influence ascribable to the hardening reaction include the influence of addition of a catalytic component for the hardening reaction on the composition, the influence of a by-product of the hardening reaction on the composition, the influence of inhibition of hardening, the influence of shrinkage, etc. ascribable to the hardening reaction, and the influence of handling so as not to or so as to cause the hardening reaction of the composition. Hence, with the non-curable polyorganosiloxane being used, the thermally conductive resin composition can have much better handleability.

Examples of the addition curable silicone resin include polyorganosiloxane prepared through the reaction between polyorganosiloxane having two or more alkenyl groups in a molecule and polyorganosiloxane containing two or more SiH groups in a molecule. In this silicone resin (b), the alkenyl groups of the polyorganosiloxane and the SiH groups of the polyorganosiloxane cause addition reaction in the presence of a platinum catalyst so that hardening proceeds. Such an addition reactive silicone resin (b) generates no by-product during hardening and can therefore eliminate the influence of the by-product on a hardened product. The two or more alkenyl groups in the polyorganosiloxane are not particularly limited, and examples include vinyl groups bound to silicon atoms.

The addition curable polyorganosiloxane is not particularly limited, and examples include ones having a structure where two or more methyl groups or phenyl groups of polyorganosiloxane are substituted with alkenyl groups such as vinyl groups or SiH groups, for example, polydimethylsiloxane, polymethylphenylsiloxane, polydiphenylsiloxane, and copolymers and modified forms thereof.

The position of binding of the alkenyl groups and the SiH groups in the molecule of the addition curable polyorganosiloxane is not particularly limited. In the case of linear polyorganosiloxane, the alkenyl groups may be bound to the side chain thereof, may be bound to the ends, or may be bound to the side chain and the end.

Examples of the condensation curable silicone resin include polyorganosiloxane having two or more hydroxyl groups and/or alkoxy groups in a molecule. These hydroxyl groups and/or alkoxy groups of the polyorganosiloxane cause condensation reaction so that hardening proceeds. Such an addition reactive silicone resin (b) tends to be more insusceptible to the inhibition of hardening than the condensation curable type.

[Thermally conductive filler (c)]

The thermal conductivity of the thermally conductive filler (c) is 10 W/mK or more, preferably 15 to 3000 W/mK, and more preferably 30 to 2000 W/mK. When a thermal conductivity of the thermally conductive filler (c) is 10 W/mK or more, the thermal conductivity of the thermally conductive resin composition tends to be more improved.

The thermally conductive filler (c) is not particularly limited, and examples include aluminum, aluminum hydroxide, aluminum oxide, aluminum nitride, silica, boron nitride, zinc oxide, magnesium oxide, diamond, carbon, indium, gallium, copper, silver, iron, nickel, gold, tin, and metal silicon. Of these, one or more selected from among aluminum, aluminum hydroxide, aluminum oxide, aluminum nitride, silica, boron nitride, zinc oxide, magnesium oxide, and diamond is preferable. With such a thermally conductive filler (c) being used, the thermal conductive property tends to be more improved.

The average particle size based on volume of the thermally conductive filler (c) is preferably 0.1 to 150 $\mu$m, and more preferably 0.1 to 120 $\mu$m. When an average particle size of the thermally conductive filler (c) is within the above range, the fluidity and the dispersibility of the thermally conductive filler are more improved and the voids and cracks tend to be more prevented. When a plurality of types of thermally conductive fillers (c) are used, the average particle size of each thermally conductive filler (c) preferably satisfies the above range. When a plurality of types of thermally conductive fillers (c) are used, the fluidity and the dispersibility of the thermally conductive filler can be enhanced, even if the filler content is high, by blending particles from large to small particle sizes at an appropriate ratio in consideration of the average particle size of each thermally conductive filler (c) so as to attain dense filling.

The content of the thermally conductive filler (c) is, based on the total 100 parts by weight of the copolymer (a) and the silicone resin (b), 500 to 3000 parts by weight, preferably 750 to 2800 parts by weight, more preferably 1000 to 2600 parts by weight, and further preferably 1500 to 2600 parts by weight. When a content of the thermally conductive filler (c) is within the above range, the fluidity and the dispersibility of the thermally conductive filler are more improved and the voids and cracks are more prevented.

[Surface treatment agent (d)]

The thermally conductive resin composition of the present embodiment may further comprise a surface treatment agent (d) which surface treats the thermally conductive filler (c). By comprising such a surface treatment agent (d), the fluidity and the dispersibility of the thermally conductive filler are more improved and the voids and cracks tend to be more prevented.

The surface treatment agent (d) is not particularly limited, and examples include silane coupling agents including epoxysilane such as $\gamma$-glycidoxypropyltrimethoxysilane and $\beta$-(3,4-epoxycyclohexyl)ethyltrimethoxysilane; aminosilane such as aminopropyltriethoxysilane, ureidopropyltriethoxysilane, and N-phenylaminopropyltrimethoxysilane; and hydrophobic silane compounds such as phenyltrimethoxysilane, methyltrimethoxysilane, octadecyltrimethoxysilane, and n-decyltrimethoxysilane. The method for surface treating the thermally conductive filler (c) with the surface treatment agent (d) is not particularly limited, and, for example, a known wet treatment method or dry treatment method can be used.

The content of the surface treatment agent (d) is, based on 100 parts by weight of the thermally conductive filler (c), 0.01 to 5 parts by weight, more preferably 0.02 to 2 parts by weight, and further preferably 0.05 to 1 parts by weight. When a content of the surface treatment agent (d) is within the above range, the dispersibility of the thermally conductive filler (c) tends to be more improved.

[Electronic device]

The electronic device of the present embodiment comprises a heat generator, a heat sink, and the above thermally conductive resin composition or a hardened product thereof, wherein the thermally conductive resin composition or the hardened product is disposed between the heat generator and the heat sink. In this electronic device, the heat generator and the heat sink are thermally bonded via the thermally conductive resin composition.

The heat generator herein is not particularly limited, and examples include heat-generating electronic components such as motors, battery packs, circuit boards used in the in-vehicle power supply system, power transistors, and microprocessors. Of these, electronic components used in an in-vehicle power supply system for vehicles are preferable. The heat sink is not particularly limited as long as it is a part constituted for the purpose of radiating heat or absorbing heat.

The method for bonding a heat generator and a heat sink via the thermally conductive resin composition is not particularly limited. For example, the electronic device can be obtained by bonding a heat generator and a heat sink using the hardened or semi-hardened thermally conductive resin composition heated in advance, or a heat generator and a heat sink are joined using the thermally conductive resin composition and then bonded by heating to obtain the electronic device. The heating condition is not particularly limited and examples include a condition of 25°C to 200°C for 0.5 hours to 24 hours.

Examples

Hereinafter, the present invention will be described more specifically in reference to Examples and Comparative Examples. The present invention is in no way limited by the following examples.

<Monomer for preparing copolymers (a)>

The following raw materials were used for polymerization of the copolymers of Examples.

((Meth)acrylic monomer A having an anionic group)

(A-1) Acrylic acid, manufactured by TOAGOSEI CO., LTD.
(A-2) 4-hydroxyphenyl methacrylate, manufactured by Seiko Chemical Co., Ltd.
(A-3) 2-Methacryloyloxyethyl acid phosphate, "LIGHT ESTER P-1M" manufactured by KYOEISHA CHEMICAL Co., LTD.
(A-4) 2-Acrylamido-2-methylpropanesulfonic acid, manufactured by Tokyo Chemical Industry Co., Ltd.

((Meth)acrylic monomer B having a cationic group)

(B) 1,2,2,6,6-Pentamethyl-4-piperidyl methacrylate, "ADEKA STAB LA-82" manufactured by ADEKA CORPORATION

((Meth)acrylic monomer C)

(C) $\alpha$-Butyl-$\omega$-(3-methacryloxypropyl)polydimethylsiloxane), "Silaplane FM-0721", manufactured by JNC Corporation, number average molecular weight 5,000

<Preparation of copolymers (a)>

(Copolymer 1)

The preparation of the copolymers was carried out by the following method. First, 100 parts by weight of (meth)acrylic monomers consisting of acrylic acid: 15 mol%, 1,2,2,6,6-pentamethyl-4-piperidyl methacrylate: 2.0 mol%, and $\alpha$-butyl-$\omega$-(3-methacryloxypropyl)polydimethylsiloxane: 83 mol% was added to an autoclave with a stirrer. Then, 0.05 parts by weight of azobisisobutyronitrile (manufactured by Tokyo Chemical Industry Co., Ltd.) as an initiator were added to 100 parts by weight in total of (meth)acrylic monomers and 1000 parts by weight of a mixed solution as a solvent having a volume ratio of toluene (guaranteed reagent) to 2-propanol (guaranteed reagent) = 7:3 were added, and the autoclave was purged with nitrogen. Subsequently, the autoclave was heated in an oil bath at 65°C for 20 hours to carry out the radical polymerization. After completion of the polymerization, deaeration was carried out under reduced pressure at 120°C for 1 hour thereby to obtain Copolymer 1.
A polymerization percentage based on 100% of the monomer amount charged was 98% or more when analyzed by the gas chromatography analysis. Based on this finding, the ratio of each monomer unit the copolymer had was estimated to be about the same as the monomer ratio charged.
Further, the weight average molecular weight of the obtained Copolymer 1 was determined using the GPC (gel permeation chromatography) method as a weight average molecular weight in term of standard polystyrene. Measurement conditions are as follows.
High-speed GPC device: "HLC-8020" manufactured by TOSOH CORPORATION

Column: 1 column of "TSK guard column MP (xL)" manufactured by TOSOH CORPORATION having 6.0 mm ID × 4.0 cm, and 2 columns of "TSK-GELMULTIPOREHXL-M" manufactured by TOSOH CORPORATION having 7.8 mm ID × 30.0 cm (number of theoretical plates 16,000 plates), total 3 columns (number of theoretical plates as a whole 32,000 plates)

Eluent: Tetrahydrofuran
Detector: RI (differential refractometer)

(Copolymers 2 to 13)

The radical polymerization was carried out by the same method as in Copolymer 1 in the exception that the monomers having the compositions shown in Tables 1 to 4 were used thereby to obtain Copolymers 2 to 13. The polymerization ratios of the obtained Copolymers 2 to 13 were all 98% or more, and thus the ratio of each monomer unit the copolymer had was estimated to be about the same as the monomer ratio charged. Further, the weight average molecular weight was determined in the same manner as in the above.

The monomer compositions shown in Tables 1 to 4 were described by molar ratio (%). The molar ratio was calculated from the addition amount and molecular weight of each monomer. The molar ratio of α-butyl-ω-(3-methacryloxypropyl)polydimethylsiloxane was calculated based on weight average molecular weights thereof.

The compositions and weight average molecular weights of Copolymers 1 to 13 synthesized as described above are shown in Tables 1 to 4 below.

<Raw materials for preparing resin compositions>

(Silicone resin (b))

(Crosslinked silicone resin (b-1))

- Vinyl-modified silicone oil: manufactured by Elkem Japan K.K., "621V100"
- SiH-modified silicone oil: manufactured by Elkem Japan K.K., "620V20"

(Non-crosslinked silicone resin (b-2))

- Silicone oil: "KF-96-300CS" manufactured by Shin-Etsu Chemical Co., Ltd., dimethyl silicone oil, viscosity 300 mPa·s

- Silicone oil: "KF-96-1000000CS" manufactured by Shin-Etsu Chemical Co., Ltd., dimethyl silicone oil, viscosity 1000000 mPa·s

(Thermally conductive filler (c))

- Aluminum oxide: manufactured by Denka Company Limited, "DAW45", average particle size: 45 μm, thermal conductivity 35 W/mK

- Aluminum oxide: manufactured by Denka Company Limited, "DAW20", average particle size: 20 μm, thermal conductivity 35 W/mK

- Aluminum oxide: manufactured by Denka Company Limited, "DAW05", average particle size: 5 μm, thermal conductivity 35 W/mK

- Aluminum oxide: manufactured by Denka Company Limited, "ASFP40", average particle size: 0.4 μm, thermal conductivity 35 W/mK

- Boron nitride: manufactured by Denka Company Limited, "SGP", average particle size: 18 μm, thermal conductivity 80 W/mK

- Aluminum nitride: manufactured by MARUWA Co., Ltd., "S-50", average particle size: 50 μm, thermal conductivity 170 W/mK

- Aluminum nitride: manufactured by MARUWA Co., Ltd., "A-05-F", average particle size: 5 μm, thermal conductivity 170 W/mK

- Aluminum nitride: manufactured by MARUWA Co., Ltd., "A-01-F", average particle size: 1 μm, thermal conductivity 170 W/mK

- Magnesium oxide: manufactured by Denka Company Limited, "DMG120", average particle size: 120 μm, thermal conductivity 60 W/mK

(Silane coupling agent)

- n-Decyltrimethoxysilane: manufactured by Dow Toray Co., Ltd., "DOWSIL Z-6210 Silane"

The average particle size of the thermally conductive filler (c) was measured using a "laser diffraction particle size analyzer SALD-20" manufactured by Shimadzu Corporation. For an evaluation sample, 50 ml of pure water and 5 g of the thermally conductive filler to be measured were added to a glass beaker, stirred using a spatula, and subsequently dispersed for 10 minutes in an ultrasonic cleaner. The dispersion of the dispersed thermally conductive filler was added drop by drop using a dropper to a sampler part of the analyzer to carry out the measurement at which an absorbance was stabilized. D50 (median diameter) was employed for the average particle size.

<Preparation of resin compositions>

(Examples 1 to 24 and Comparative Examples 1 to 8)

The copolymer (a), the silicone resin (b), the thermally conductive filler (c), and the silane coupling agent were mixed according to the composition shown in Tables 1 to 4 to prepare a resin composition. The evaluation described below was performed using each resin composition obtained. The results are shown in Tables 1 to 4.

[Viscosity]

In a rotary rheometer MARS III, manufactured by Thermo Scientific, with a 35 mmφ-parallel plate as the upper jig, the resin composition was placed on a 35 mmφ-lower plate temperature controllable by a Peltier element, compressed to a thickness of 1 mm by the upper jig, the part stuck out was scraped off, and the measurement was carried out at 25°C. A viscosity at a shear velocity of 1 to 10 s$^{-1}$ was measured.

[Crack resistance]

A sample, which was obtained by preparing two 76 mm-square non-alkali glass plates, coating the resin composition at the center of one of the glass plates in such a way as to have a diameter of 20 mm and a thickness of 1 mm, interposing the composition with the other glass plate, was retained under the environment of 150°C, and a heat resistance test was carried out. After 24 hour-retention, the presence or absence of cracks was visually confirmed.
Specifically, a photograph of the test piece after the heat resistance evaluation test was taken, and the image data was binarized using an image processing software. In the binarized image, the black parts show the gaps caused by cracks of the resin composition, and the white parts show the parts where the resin composition exists. An image binarized like this for each of Examples and Comparative Examples was created, and a crack resistance rate was calculated based on the image. More specifically, an area ratio of the black parts was calculated from the entire area and defined as a crack rate. The evaluation criteria for the crack resistance are shown below.

    A: Crack rate of 0% or more and less than 1%
    B: Crack rate of 1% or more and less than 5%
    C: Crack rate of 5% or more and less than 15%
    D: Crack rate of 15% or more

[Dripping]

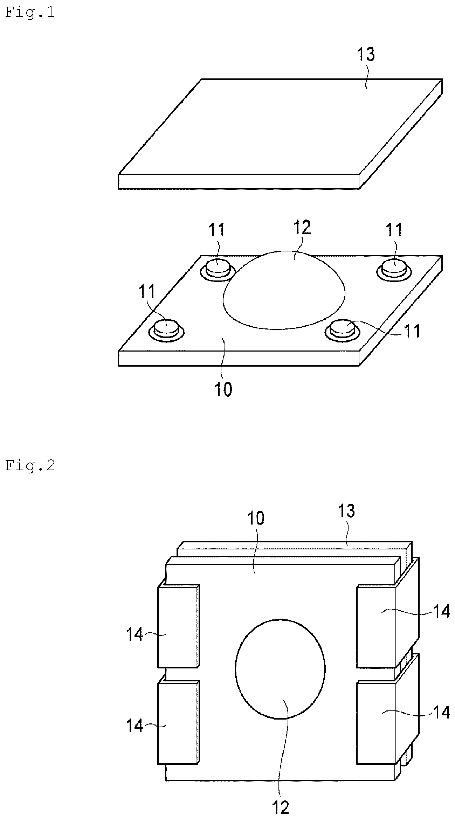

The dripping property of a thermally conductive hardened product was evaluated by the testing methods shown in Figures 1 and 2. First, as shown in Figure 1, shims 11 having a thickness of 2 mm were placed on four corners of an 80 mm × 80 mm glass plate 10, and a mixture 12 obtained by mixing a first agent and a second agent at a volume ratio of 1:1 was coated in a circular shape on substantially the central part of the glass plate 10 and sandwiched between the glass plate 10 and an 80 mm × 80 mm glass plate 13. The amount of the mixture 12 coated was set to an amount such that the size of the formed circular shape of the mixture sandwiched between the glass plates 10 and 13 was 25 mm$\phi$. Subsequently, as shown in Figure 2, the glass plates 10 and 13 were secured by clips 14 and allowed to stand in a vertical placement. After standing at 25°C for 24 hours, the creeping of the thermally conductive hardened product from the initial position was observed to evaluate the dripping property.

[Bleed-out resistance]

On a 76 mm-square frosted glass, 0.65 g of the resin composition was coated in a substantially circular shape. The coated glass was allowed to stand for 24 hours in an oven at 150°C, and then taken out of the oven. When bleed-out is found, the liquid ingredients seeped out and formed a gray circle around the resin composition in a substantially circular shape. Using the size of this circle as the indicator for a bleed-out amount, the maximum length from the edge part of the white resin composition to the edge of the gray circle was defined as the bleed-out amount and evaluated.

[Thermal conductivity]

The resin composition was interposed between a cuboidal copper jig with an embedded heater and having an end of 100 mm$^2$ (10 mm × 10 mm) and a cuboidal copper jig equipped with a cooling fin and having an end of 100 mm$^2$ (10 mm × 10 mm), and a thermal resistance was measured with a gap thickness ranging from 0.05 mm to 0.30 mm, thereby calculating a thermal conductivity from the thermal resistance and the thickness gradient to be evaluated. The thermal resistance was calculated by retaining electricity of 10 W applied to the heater for 30 minutes, measuring a temperature difference (°C) between the copper jigs, and using the following expression:

```
Thermal resistance (°C/W) = {temperature difference

(°C)/electricity (W)}.
```

[Table 1]

| | | | | | Example | | | | | | | |
|---|---|---|---|---|---|---|---|---|---|---|---|---|
| | | | | | 1 | 2 | 3 | 4 | 5 | 6 | 7 | 8 |
| Copolymer (a) | Unit A | (A-1) | Acrylic acid | mol% | 15 | 15 | 15 | 68 | 68 | 68 | 68 | 68 |
| | | (A-2) | 4-Hydroxyphenyl methacrylate | | | | | | | | | |
| | | (A-3) | 2-Methacryloyloxyethyl acid phosphate | | | | | | | | | |
| | | (A-4) | 2-Acrylamido-2-methylpropanesulfonic acid | | | | | | | | | |
| | Unit B | (B) | 1,2,2,6,6-Pentamethyl-4-piperidyl methacrylate | | 2 | 2 | 0.5 | 2 | 2 | 2 | 2 | 2 |
| | Unit C | (C) | $\alpha$-Butyl-$\omega$-(3-methacryloxypropyl) polydimethylsiloxane | | 83 | 83 | 84.5 | 30 | 30 | 30 | 30 | 30 |
| | Copolymer No. | | | | 1 | 1 | 2 | 3 | 3 | 3 | 3 | 3 |
| | Weight average molecular weight | | | | 20000 | 20000 | 19000 | 60000 | 60000 | 60000 | 60000 | 60000 |

(continued)

| | | | | Example | | | | | | | |
|---|---|---|---|---|---|---|---|---|---|---|---|---|
| | | | | | 1 | 2 | 3 | 4 | 5 | 6 | 7 | 8 |
| Resin composition | Copolymer (a) | | | Parts by weight | 6 | 6 | 6 | 6 | 20 | 40 | 80 | 20 |
| | Silicone resin (b) | (b-1) | 621V100 | | 14 | 14 | 14 | 14 | 12 | 9 | 3 | 62 |
| | | | 620V20 | | 4 | 4 | 4 | 4 | 4 | 3 | 1 | 18 |
| | | (b-2) | Silicone oil KF-96-300CS | | 76 | 76 | 76 | 76 | 64 | 48 | 16 | |
| | | | Silicone oil KF-96-1,000,000CS | | | | | | | | | |
| | Thermally conductive filler (c) | | Aluminum oxide (average particle size: 45$\mu$m) | | 550 | 1800 | 1000 | 1000 | 1000 | 1000 | 1000 | 1000 |
| | | | Aluminum oxide (average particle size: 20$\mu$m) | | 50 | 150 | 85 | 85 | 85 | 85 | 85 | 85 |
| | | | Aluminum oxide (average particle size: 5$\mu$m) | | 50 | 150 | 85 | 85 | 85 | 85 | 85 | 85 |
| | | | Aluminum oxide (average particle size: 0.4$\mu$m) | | 280 | 900 | 500 | 500 | 500 | 500 | 500 | 500 |
| | | | Boron nitride (average particle size: 18$\mu$m) | | | | | | | | | |
| | | | Aluminum nitride (average particle size: 50$\mu$m) | | | | | | | | | |
| | | | Aluminum nitride (average particle size: 5$\mu$m) | | | | | | | | | |
| | | | Aluminum nitride (average particle size: 1 $\mu$m) | | | | | | | | | |
| | | | Magnesium oxide (average particle size: 120$\mu$m) | | | | | | | | | |
| | Silane coupling agent | | n-Decyltrimethoxysilane | | 2 | 2 | 2 | 2 | 2 | 2 | 2 | 2 |

(continued)

| | | | Example | | | | | | | |
|---|---|---|---|---|---|---|---|---|---|---|
| | | | 1 | 2 | 3 | 4 | 5 | 6 | 7 | 8 |
| | Viscosity of resin composition | Pa·s | 160 | 960 | 450 | 480 | 350 | 870 | 1000 | 560 |
| | Crack resistance | | A | A | A | A | A | A | A | A |
| | Dripping | mm | 0 | 0 | 0 | 0 | 1 | 0 | 0 | 0 |
| | Bleed-out resistance | mm | 1.5 | 0.5 | 1.0 | 1.0 | 1.0 | 1.0 | 1.0 | 0.5 |
| | Thermal conductivity | W/mK | 2.2 | 5.8 | 5.0 | 5.0 | 5.0 | 5.0 | 5.0 | 5.0 |

[Table 2]

| | | | | | | Example | | | | | | | |
|---|---|---|---|---|---|---|---|---|---|---|---|---|---|
| | | | | | | 9 | 10 | 11 | 12 | 13 | 14 | 15 | 16 |
| Copolymer (a) | Unit A | (A-1) | Acrylic acid | mol% | | 68 | 68 | 5 | 0.5 | 0.1 | | | |
| | | (A-2) | 4-Hydroxyphenyl methacrylate | | | | | | | | 0.5 | | |
| | | (A-3) | 2-Methacryloyloxyethyl acid phosphate | | | | | | | | | 0.5 | |
| | | (A-4) | 2-Acrylamido-2-methylpropanesulfonic acid | | | | | | | | | | 0.5 |
| | Unit B | (B) | 1,2,2,6,6-Pentamethyl-4-piperidyl methacrylate | | | 2 | 2 | 0.1 | 0.5 | 5 | 0.5 | 0.5 | 0.5 |
| | Unit C | (C) | $\alpha$-Butyl-$\omega$-(3-methacryloxypropyl) polydimethylsiloxane | | | 30 | 30 | 94.9 | 99 | 94.9 | 99 | 99 | 99 |
| | | | Copolymer No. | | | 3 | 3 | 5 | 6 | 7 | 8 | 9 | 10 |
| | | | Weight average molecular weight | | | 60000 | 60000 | 7500 | 8000 | 6800 | 6800 | 6800 | 6800 |

(continued)

| Resin composition | | | | | Example | | | | | | | |
|---|---|---|---|---|---|---|---|---|---|---|---|---|
| | | | | | 9 | 10 | 11 | 12 | 13 | 14 | 15 | 16 |
| | Copolymer (a) | | | 20 | 20 | 20 | 20 | 20 | 20 | 20 | 20 |
| | Silicone resin (b) | (b-1) | 621V100 | | 25 | 49 | 12 | 12 | 12 | 12 | 12 | 12 |
| | | | 620V20 | | 7 | 15 | 4 | 4 | 4 | 4 | 4 | 4 |
| | | (b-2) | Silicone oil KF-96-300CS | | 48 | 16 | 64 | 64 | 64 | 64 | 64 | 64 |
| | | | Silicone oil KF-96-1,000,000CS | | | | | | | | | |
| | Thermally conductive filler (c) | | Aluminum oxide (average particle size: 45μm) | Parts by weight | 1000 | 1000 | 1000 | 1000 | 1000 | 1000 | 1000 | 1000 |
| | | | Aluminum oxide (average particle size: 20μm) | | 85 | 85 | 85 | 85 | 85 | 85 | 85 | 85 |
| | | | Aluminum oxide (average particle size: 5μm) | | 85 | 85 | 85 | 85 | 85 | 85 | 85 | 85 |
| | | | Aluminum oxide (average particle size: 0.4μm) | | 500 | 500 | 500 | 500 | 500 | 500 | 500 | 500 |
| | | | Boron nitride (average particle size: 18μm) | | | | | | | | | |
| | | | Aluminum nitride (average particle size: 50μm) | | | | | | | | | |
| | | | Aluminum nitride (average particle size: 5μm) | | | | | | | | | |
| | | | Aluminum nitride (average particle size: 1μm) | | | | | | | | | |
| | | | Magnesium oxide(average particle size: 120μm) | | | | | | | | | |
| | Silane coupling agent | | n-Decyltrimethoxysilane | | 2 | 2 | 2 | 2 | 2 | 2 | 2 | 2 |

EP 4 227 336 A1

19

(continued)

| | | | Example | | | | | | | |
|---|---|---|---|---|---|---|---|---|---|---|
| | | | 9 | 10 | 11 | 12 | 13 | 14 | 15 | 16 |
| | Viscosity of resin composition | Pa·s | 480 | 520 | 280 | 330 | 300 | 310 | 320 | 330 |
| | Crack resistance | | A | A | B | B | B | B | B | B |
| | Dripping | mm | 0 | 0 | 1 | 1 | 1 | 1 | 1 | 1 |
| | Bleed-out resistance | mm | 0.5 | 0.5 | 2.0 | 2.0 | 1.5 | 1.5 | 1.5 | 1.5 |
| | Thermal conductivity | W/mK | 5.0 | 5.0 | 5.0 | 5.0 | 5.0 | 5.0 | 5.0 | 5.0 |

[Table 3]

| | | | | | Example | | | | | | | |
|---|---|---|---|---|---|---|---|---|---|---|---|---|
| | | | | | 17 | 18 | 19 | 20 | 21 | 22 | 23 | 24 |
| Copolymer (a) | Unit A | (A-1) | Acrylic acid | mol% | 68 | 68 | 68 | 15 | 68 | 15 | 68 | 0.1 |
| | | (A-2) | 4-Hvdroxyphenyl methacrylate | | | | | | | | | |
| | | (A-3) | 2-Methacryloyloxyethyl acid phosphate | | | | | | | | | |
| | | (A-4) | 2-Acrylamido-2-methylpropanesulfonic acid | | | | | | | | | |
| | Unit B | (B) | 1,2,2,6,6-Pentamethyl-4-piperidyl methacrylate | | 2 | 2 | 2 | 2 | 2 | 2 | 2 | 5 |
| | Unit C | (C) | $\alpha$-Butyl-$\omega$-(3-methacryloxypropyl) polydimethylsiloxane | | 30 | 30 | 30 | 83 | 30 | 83 | 30 | 94.9 |
| | | | Copolymer No. | | 3 | 3 | 3 | 1 | 3 | 1 | 3 | 7 |
| | | | Weight average molecular weight | | 60000 | 60000 | 60000 | 20000 | 60000 | 20000 | 60000 | 6800 |

| | | | | Example | | | | | | | |
|---|---|---|---|---|---|---|---|---|---|---|---|
| | | | | | 17 | 18 | 19 | 20 | 21 | 22 | 23 | 24 |
| Resin composition | Copolymer (a) | | | Parts by weight | 40 | 40 | 40 | 40 | 40 | 40 | 40 | 40 |
| | Silicone resin (b) | (b-1) | 621V100 | | 9 | 9 | 9 | 9 | 9 | 9 | 9 | 9 |
| | | | 620V20 | | 3 | 3 | 3 | 3 | 3 | 3 | 3 | 3 |
| | | (b-2) | Silicone oil KF-96-300CS | | 48 | 48 | 48 | 48 | 48 | 48 | 48 | 48 |
| | | | Silicone oil KF-96-1,000,000CS | | | | 6 | | | | | |
| | Thermally conductive filler (c) | | Aluminum oxide (average particle size: 45μm) | | 1000 | 550 | 1000 | | | 367 | 367 | |
| | | | Aluminum oxide (average particle size: 20μm) | | 85 | 50 | 85 | | | 117 | 117 | |
| | | | Aluminum oxide (average particle size: 5μm) | | 85 | 50 | 85 | | | 468 | 468 | |
| | | | Aluminum oxide (average particle size: 0.4μm) | | 500 | 280 | 500 | | | 217 | 217 | |
| | | | Boron nitride (average particle size: 18μm) | | | | | | | | | 550 |
| | | | Aluminum nitride (average particle size: 50μm) | | | | | 1000 | 1000 | | | |
| | | | Aluminum nitride (average particle size: 5μm) | | | | | 420 | 420 | | | |
| | | | Aluminum nitride (average particle size: 1 μm) | | | | | 250 | 250 | | | |
| | | | Magnesium oxide(average particle size: 120μm) | | | | | | | 501 | 501 | |
| | Silane coupling agent | | n-Decyltrimethoxysilane | | | 50 | 2 | 2 | 2 | 2 | 2 | 2 |

EP 4 227 336 A1

22

(continued)

| | | Example | | | | | | | |
|---|---|---|---|---|---|---|---|---|---|
| | | 17 | 18 | 19 | 20 | 21 | 22 | 23 | 24 |
| Viscosity of resin composition | Pa·s | 570 | 100 | 860 | 670 | 720 | 500 | 530 | 750 |
| Crack resistance | | A | A | A | A | A | A | A | A |
| Dripping | mm | 0 | 2 | 0 | 0 | 0 | 0 | 0 | 0 |
| Bleed-out resistance | mm | 1.5 | 3.0 | 0.5 | 1.0 | 1.0 | 0.5 | 0.5 | 1.5 |
| Thermal conductivity | W/mK | 5.0 | 1.8 | 5.0 | 5.7 | 5.7 | 7.3 | 7.3 | 2.2 |

[Table 4]

| | | | | | Comparative Example | | | | | | | |
|---|---|---|---|---|---|---|---|---|---|---|---|---|
| | | | | | 1 | 2 | 3 | 4 | 5 | 6 | 7 | 8 |
| Copolymer (a) | Unit A | (A-1) | Acrylic acid | mol% | 15 | 15 | 68 | 15 | 80 | 15 | | 68 |
| | | (A-2) | 4-Hydroxyphenyl methacrylate | | | | | | | | | |
| | | (A-3) | 2-Methacryloyloxyethyl acid phosphate | | | | | | | | | |
| | | (A-4) | 2-Acrylamido-2-methylpropanesulfonic acid | | | | | | | | | |
| | Unit B | (B) | 1,2,2,6,6-Pentamethyl-4-piperidyl methacrylate | | 2 | 2 | 2 | 2 | 20 | | 2 | 2 |
| | Unit C | (C) | $\alpha$-Butyl-$\omega$-(3-methacryloxypropyl) polydimethylsiloxane | | 83 | 83 | 30 | 83 | | 85 | 98 | 30 |
| | Copolymer No. | | | | 1 | 1 | 3 | 1 | 11 | 12 | 13 | 3 |
| | Weight average molecular weight | | | | 20000 | 20000 | 60000 | 20000 | 7400 | 8000 | 7500 | 60000 |

(continued)

| Resin composition | | | | | Comparative Example | | | | | | | |
|---|---|---|---|---|---|---|---|---|---|---|---|---|
| | | | | | 1 | 2 | 3 | 4 | 5 | 6 | 7 | 8 |
| | Copolymer (a) | | | Parts by weight | 2 | 97 | 6 | 6 | 6 | 6 | 6 | 20 |
| | Silicone resin (b) | (b-1) | 621V100 | | 15 | 2 | 14 | 14 | 14 | 14 | 14 | 2 |
| | | | 620V20 | | 5 | 1 | 4 | 4 | 4 | 4 | 4 | 1 |
| | | (b-2) | Silicone oil KF-96-300CS | | 78 | 1 | 76 | 76 | 76 | 76 | 76 | 78 |
| | | | Silicone oil KF-96-1,000,000CS | | | | | | | | | |
| | Thermally conductive filler (c) | | Aluminum oxide (average particle size: 45μm) | | 1000 | 1000 | 2100 | 270 | 1000 | 1000 | 1000 | 1000 |
| | | | Aluminum oxide (average particle size: 20μm) | | 85 | 85 | 175 | 25 | 85 | 85 | 85 | 85 |
| | | | Aluminum oxide (average particle size: 5μm) | | 85 | 85 | 175 | 25 | 85 | 85 | 85 | 85 |
| | | | Aluminum oxide (average particle size: 0.4μm) | | 500 | 500 | 1050 | 135 | 500 | 500 | 500 | 500 |
| | | | Boron nitride (average particle size: 18μm) | | | | | | | | | |
| | | | Aluminum nitride (average particle size: 50μm) | | | | | | | | | |
| | | | Aluminum nitride (average particle size: 5μm) | | | | | | | | | |
| | | | Aluminum nitride (average particle size: 1μm) | | | | | | | | | |
| | | | Magnesium oxide(average particle size: 120μm) | | | | | | | | | |
| | Silane coupling agent | | n-Decyitrimethoxysilane | | 2 | 2 | 2 | 2 | 2 | 2 | 2 | 2 |

(continued)

| | | Comparative Example | | | | | | | |
| --- | --- | --- | --- | --- | --- | --- | --- | --- | --- |
| | | 1 | 2 | 3 | 4 | 5 | 6 | 7 | 8 |
| Viscosity of resin composition | Pa·s | 720 | 1300 | 1800 | 20 | 550 | 640 | 620 | 560 |
| Crack resistance | | C | C | D | B | D | D | D | B |
| Dripping | mm | 2 | 4 | 0 | 8 | 5 | 3 | 3 | 6 |
| Bleed-out resistance | mm | 6.0 | 1.5 | 0.5 | 15.0 | 12.0 | 10.0 | 8.0 | 5.0 |
| Thermal conductivity | W/mK | 5.0 | 5.0 | 6.7 | 1.0 | 5.0 | 5.0 | 5.0 | 5.0 |

Industrial Applicability

The thermally conductive resin composition of the present invention has industrial applicability to heat radiation greases and the like for thermally connecting a heat generator and a heat sink in an electronic device.

**Claims**

1. A thermally conductive resin composition comprising:

   5 to 95 parts by weight of a copolymer (a) having a (meth)acrylic monomer unit A having an anionic group, a (meth)acrylic monomer unit B having a cationic group, and a silicone (meth)acrylic monomer unit C;
   95 to 5 parts by weight of a silicone resin (b); and
   500 to 3000 parts by weight of a thermally conductive filler (c) having a thermal conductivity of 10 W/mK or more, wherein
   a total content of the copolymer (a) and the silicone resin (b) is 100 parts by weight, and
   the silicone resin (b) comprises a crosslinked silicone resin (b-1), wherein
   a content of the crosslinked silicone resin (b-1) is 5 to 100 mass% based on the total amount of the silicone resin (b).

2. The thermally conductive resin composition according to claim 1, wherein

   the silicone resin (b) further comprises a non-crosslinked silicone resin (b-2), wherein
   the content of the crosslinked silicone resin (b-1) is 5 to 99 mass% based on the total amount of the silicone resin (b), and
   a content of the non-crosslinked silicone resin (b-2) is 95 to 1 mass% based on the total amount of the silicone resin (b).

3. The thermally conductive resin composition according to claim 2, wherein
   the non-crosslinked silicone resin (b-2) is linear polyorganosiloxane.

4. The thermally conductive resin composition according to claim 2 or 3, wherein
   a viscosity of the non-crosslinked silicone resin (b-2) is 1 to 10,000 mPa·s as a value measured at a shear velocity of 10 sec$^{-1}$ at 25°C.

5. The thermally conductive resin composition according to any one of claims 1 to 4, wherein
   the crosslinked silicone resin (b-1) is prepared through the reaction between polyorganosiloxane (b-1-1) having two or more alkenyl groups in a molecule and polyorganosiloxane (b-1-2) containing two or more SiH groups in a molecule.

6. The thermally conductive resin composition according to any one of claims 1 to 5, wherein
   the anionic group comprises one or more selected from the group consisting of carboxy groups, phosphate groups, and phenolic hydroxy groups.

7. The thermally conductive resin composition according to any one of claims 1 to 6, wherein
   the (meth)acrylic monomer unit A further has an electron-withdrawing group bound to the anionic group.

8. The thermally conductive resin composition according to any one of claims 1 to 7, wherein
   the cationic group comprises one or more selected from the group consisting of primary amino groups, secondary amino groups, tertiary amino groups, and quaternary ammonium salts.

9. The thermally conductive resin composition according to any one of claims 1 to 8, wherein
   the (meth)acrylic monomer unit B further has an electron-donating group bound to the cationic group.

10. The thermally conductive resin composition according to any one of claims 1 to 9, wherein
    a weight average molecular weight of the copolymer (a) is 5,000 to 500,000.

11. The thermally conductive resin composition according to any one of claims 1 to 10, wherein
    a total content of the (meth)acrylic monomer unit A and the (meth)acrylic monomer unit B is 0.05 to 90 mol% based on the total 100 mol% of the (meth)acrylic monomer unit A, the (meth)acrylic monomer unit B, and the silicone (meth)acrylic monomer unit C.

12. The thermally conductive resin composition according to any one of claims 1 to 11, wherein a content of the (meth)acrylic monomer unit A is 0.03 to 85 mol% based on the total 100 mol% of the (meth)acrylic monomer unit A, the (meth)acrylic monomer unit B, and the silicone (meth)acrylic monomer unit C.

13. The thermally conductive resin composition according to any one of claims 1 to 12, wherein a content of the (meth)acrylic monomer unit B is 0.1 to 10 mol% based on the total 100 mol% of the (meth)acrylic monomer unit A, the (meth)acrylic monomer unit B, and the silicone (meth)acrylic monomer unit C.

14. The thermally conductive resin composition according to any one of claims 1 to 13, wherein a content of the silicone (meth)acrylic monomer unit C is 10 to 99.5 mol% based on the total 100 mol% of the (meth)acrylic monomer unit A, the (meth)acrylic monomer unit B, and the silicone (meth)acrylic monomer unit C.

15. The thermally conductive resin composition according to any one of claims 1 to 14, wherein a molar ratio of the (meth)acrylic monomer unit A to the (meth)acrylic monomer unit B is 0.01 to 50.

16. The thermally conductive resin composition according to any one of claims 1 to 15, comprising 0.01 to 5 parts by weight of a surface treatment agent (d) based on 100 parts by weight of the thermally conductive filler (c).

17. The thermally conductive resin composition according to any one of claims 1 to 16, wherein the thermally conductive filler (c) is one or more selected from among aluminum, aluminum hydroxide, aluminum oxide, aluminum nitride, boron nitride, zinc oxide, magnesium oxide, and diamond.

18. An electronic device comprising

a heat generator, a heat sink, and the thermally conductive resin composition according to any one of claims 1 to 17 or a hardened product thereof, wherein
the thermally conductive resin composition or the hardened product is disposed between the heat generator and the heat sink.

Fig.1

Fig.2

## INTERNATIONAL SEARCH REPORT

| International application No. |
| --- |
| **PCT/JP2021/036778** |

**A. CLASSIFICATION OF SUBJECT MATTER**

*C08F 290/06*(2006.01)i; *C08F 220/26*(2006.01)i; *C08F 220/34*(2006.01)i; *C08F 220/38*(2006.01)i; *C08F 220/58*(2006.01)i; *C08F 220/60*(2006.01)i; *C08F 230/02*(2006.01)i; *C08L 51/08*(2006.01)i; *C08L 55/00*(2006.01)i; *C08L 83/04*(2006.01)i; *C08L 83/05*(2006.01)i; *C08L 83/07*(2006.01)i; *C09K 5/14*(2006.01)i; *C08K 3/01*(2018.01)i

FI: C08L51/08; C08L83/05; C08L83/07; C08L83/04; C08K3/01; C08L55/00; C08F290/06; C09K5/14 E; C08F230/02; C08F220/58; C08F220/26; C08F220/38; C08F220/34; C08F220/60

According to International Patent Classification (IPC) or to both national classification and IPC

**B. FIELDS SEARCHED**

Minimum documentation searched (classification system followed by classification symbols)

C08F290/06; C08F220/26; C08F220/34; C08F220/38; C08F220/58; C08F220/60; C08F230/02; C08L51/08; C08L55/00; C08L83/04; C08L83/05; C08L83/07; C09K5/14; C08K3/01

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
| --- | --- | --- |
| A | WO 2018/131486 A1 (DENKA COMPANY LTD) 19 July 2018 (2018-07-19) | 1-18 |
| A | JP 2017-31231 A (SHINETSU CHEMICAL CO) 09 February 2017 (2017-02-09) | 1-18 |
| A | JP 2015-140395 A (SHINETSU CHEMICAL CO) 03 August 2015 (2015-08-03) | 1-18 |
| A | CN 107325782 A (GOLOHO POLYMER CHANGZHOU CO LTD) 07 November 2017 (2017-11-07) | 1-18 |
| A | JP 60-179417 A (SHINETSU CHEM IND CO) 13 September 1985 (1985-09-13) | 1-18 |

☑ Further documents are listed in the continuation of Box C.    ☑ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |
| Date of the actual completion of the international search<br><br>**14 December 2021** | Date of mailing of the international search report<br><br>**21 December 2021** |
| Name and mailing address of the ISA/JP<br><br>**Japan Patent Office (ISA/JP)**<br>**3-4-3 Kasumigaseki, Chiyoda-ku, Tokyo 100-8915**<br>**Japan** | Authorized officer<br><br><br><br>Telephone No. |

Form PCT/ISA/210 (second sheet) (January 2015)

**INTERNATIONAL SEARCH REPORT**

International application No.

**PCT/JP2021/036778**

C.    DOCUMENTS CONSIDERED TO BE RELEVANT

| Category* | Citation of document, with indication, where appropriate, of the relevant passages | Relevant to claim No. |
|---|---|---|
| A | JP 3-30825 A (DAINIPPON INK & CHEM INC) 08 February 1991 (1991-02-08) | 1-18 |
| A | JP 2004-109179 A (DAINIPPON INK & CHEM INC) 08 April 2004 (2004-04-08) | 1-18 |
| A | JP 2016-121350 A (TOYO INK SC HOLDINGS CO LTD) 07 July 2016 (2016-07-07) | 1-18 |

Form PCT/ISA/210 (second sheet) (January 2015)

**INTERNATIONAL SEARCH REPORT**
Information on patent family members

| | | International application No. |
|---|---|---|
| | | **PCT/JP2021/036778** |

| Patent document cited in search report | | | Publication date (day/month/year) | Patent family member(s) | Publication date (day/month/year) |
|---|---|---|---|---|---|
| WO | 2018/131486 | A1 | 19 July 2018 | (Family: none) | |
| JP | 2017-31231 | A | 09 February 2017 | (Family: none) | |
| JP | 2015-140395 | A | 03 August 2015 | (Family: none) | |
| CN | 107325782 | A | 07 November 2017 | (Family: none) | |
| JP | 60-179417 | A | 13 September 1985 | US    4584342    A | |
| JP | 3-30825 | A | 08 February 1991 | (Family: none) | |
| JP | 2004-109179 | A | 08 April 2004 | (Family: none) | |
| JP | 2016-121350 | A | 07 July 2016 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018062552 A
- JP 2017226724 A
- JP 2015140395 A
- JP 5300408 B